# EUROPÄISCHE PATENTANMELDUNG

(11) **EP 2 133 199 A1**
(43) Veröffentlichungstag der Anmeldung: **16.12.2009**
(21) Anmeldenummer: 09006499.9
(22) Anmeldetag: 14.05.2009
(51) Int. Cl.: B32B 9/02, B32B 29/00, B65D 65/40, B65D 65/46

(54) **Kompostierbare Verpackung für elektronische Bauelemente**

(30) Priorität: 13.06.2008 DE 102008028394
(71) Anmelder: Amphenol-Tuchel Electronics GmbH, 74080 Heilbronn (DE)
(72) Erfinder: Nitsche, Axel, 74078 Heibronn (DE); Korber, Franz, 74081 Heilbronn (DE)

(57) **Zusammenfassung**

Die Erfindung betrifft eine Verbundverpackung für elektrische Bauelemente aus mindestens zwei Schichten, wobei die Schichtmaterialien der Schichten sowohl einzeln als auch in Kombination miteinander vollständig bioabbaubar oder kompostierbar sind.

## Beschreibung

Die Erfindung betrifft Verpackungen gemäß dem Oberbegriff von Anspruch 1.

Die Erfindung betrifft insbesondere Verpackungen in Nanopad-Technologie und im allgemeinen für elektronische Bauelemente. Insbesondere betrifft die Erfindung kompostierbare Verpackungen, welche eine Vielzahl von in Reihe angeordneter elektronischer Bauelemente auf deren Oberfläche aufweist. Weiterhin betrifft die Erfindung daher eine Verpackung, ausgebildet aus Verbundmehrschichtfolien, welche vollständig kompostierbar ist.

### Stand der Technik

Kompostierbare beziehungsweise bioabbaubare Behälter beziehungsweise Verpackungen sind seit längerem bekannt. Zum Beispiel ist aus der EP 0641817 A2 bekannt, dass an sich thermoplastisch verarbeitbare und biologisch abbaubare Materialien für biologisch abbaubare kompostierbare Folien verwendet werden. Dort werden Polyesteramide, beispielsweise aus Adipinsäure, Butandiol und Aminocapronsäure offenbart, die im biologischen Abbautest erfolgreiche Ergebnisse zeigen. Als kompostierbar oder biologisch abbaubar im Sinne der vorliegenden Erfindung werden auch Proben bezeichnet, die unter bestimmten Bedingungen innerhalb von wenigen Wochen ein Biomassenwachstum von mindestens 30 mg/l ermöglichen. Allerdings können auch niedrigere oder höhere Werte in Betracht gezogen werden, wenn letztendlich das Material ein Biomassewachstum derart aufweist, dass die zu betrachtende Verpackung beziehungsweise die zu betrachtende Verbundmehrschichtverpackungen vollständig kompostierbar beziehungsweise bioabbaubar ist.

Zum Stand der Technik gehören ebenfalls als Kleber für Kaschierungen von Folienmaterialien eingesetzte gemischte Polyurethan-Prepolymere, wie sie aus der EP0150444 B1 bekannt sind. Diese Polyurethan-Prepolymere weisen endständige Isocyanatendgruppen auf.

Die Isocyanaten haben unterschiedliche Aktivität und eignen sich in Substanz oder alternativ In wässriger Lösung zum Verbinden insbesondere zum Verkleben von Kunststoffen beziehungsweise Kunststofffolien, insbesondere zum Kaschieren von Kunststofffolien. Es ist bekannt, dass mit solchen Produkten hergestellte Folienverbunde eine hohe Verarbeitungssicherheit zeigen. Die Wirkung wird darauf zurückgeführt, dass ein verminderter Anteil migrationsfähiger niedermolekularer Produkte in den Prepolymehren vorhanden ist und der Effekt diesen zugeschrieben wird. Nachteilig im Stand der Technik ist, dass über die biologische Abbaubarkeit solcher Kleber bislang wenig bekannt ist.

In der PCT/EP97/04389 wird eine gut kompostierbare Verbundmehrschichtfolie offenbart, sowie ein Verfahren zu deren Herstellung sowie Verwendung derselben.

Die genannte Erfindung betrifft eine kompostierbare Verbundmehrschichtfolie mit wenigstens eine Barriereschicht aus Polyvinylalkohol, auf welche beidseitig ein oder mehrere Folien mittels eines Klebers aufkaschiert oder mittels Coextrusion oder durch Heißbeschichtung aufgebracht sind, ein Verfahren zur Herstellung solcher Verbundmehrschichtfolien und auch deren Verwendung.

Diese Erfindung hat es sich zur Aufgabe gestellt, einen Polyethylen- oder allgemein einen Polyolefinfoliensatz zur Verfügung zu stellen, welcher eine entsprechende Zwischensicht enthält, so dass alle Anforderungen an Barrieren erfüllt werden und der trotzdem alle verarbeitungstechnischen Anforderungen an einen Folienverbund erfüllt und zugleich hervorragend biologisch abbaubar beziehungsweise kompostierbar ist.

Zur Untersuchung der Kompostierbarkeit der im Stand der Technik bekannten Verbundwerkstoffe und Verpackungsmittel existieren eine Reihe von Tests, wie zum Beispiel Tests mit isolierten Enzymen, Folien-Kompostiertests, bei denen Folien bei einer definierten Temperatur in ausgereiften Kompost eingegraben und der biologische Abbau visuell beurteilt wird. Alternativ dazu gibt es Abbautest in Kompostierversuchen mittels Erdeingrabung.

Im erfindungsgemäßen Sinne heißt gut kompostierbar, dass ein Material im biologischen Abbautest eine definierte Biomasse erzeugt, welche > 20mg/l nach dem Abbautest ASTM G22 ergibt.

In den bevorzugten Ausführungsformen der hier vorliegenden Erfindung wird von einem Verbundmaterial ausgegangen, welche typische Werte solcher biologischen Abbautest erfüllen beziehungsweise diese übertreffen.

Die Messmethode wird im einzelnen nicht weiter erläutert, da diese im Stand der Technik hinreichend bekannt ist. Neben Messmethoden ist auch der visuelle Effekt nach einer definierten Zeit von wenigen Wochen eine gute Aussagemöglichkeit um den Biomassetest beziehungsweise Abbautest zu überprüfen auf deren Erfolg und Wirkung.

Im Stand der Technik sind auch biologisch abbaubare und kompostierbare Behälter beziehungsweise Verpackungen bekannt, welche aus Papierstärke oder Cellulose und weiteren organischen Bestandteilen bestehen, insbesondere essbare Behälter, zum Beispiel Waffeln für Speiseeis oder Behälter, welcher aus Waffelgebäck auf Fettbasis erzeugt werden.

So ist in der DE OS 36 43 199 ein Behälter vorgeschlagen, mit verschiedenen Imprägnierungen auf Fettbasis und einer Beschichtung die frei ist von Saccharose.

Eine weitere Offenbarung bietet die DE AS 1 221 585, welche ebenfalls Verpackungen mit einer Fettgrundierung imprägniert und anschließend mit einer Dispersion ausstattet. Diese Verpackungen sind essbar und daher biologisch abbaubar und kompostierbar.

Nachteilig bei den zuvor genannten Verpackungen ist insbesondere die mangelnde mechanische Stabilität, insbesondere bei den essbaren Verpackungen zu sehen, sowie Empfindlichkeit gegen Feuchte und andere äußere Einflüsse. Diese zuvor genannten Verpackungen weisen darüber hinaus nicht die gewünschten Eigenschaften auf, um elektronische Bauelemente in der Massenproduktion aufzunehmen und diese beispielsweise in die Form einer Tape and Reel-Verpackung zu formen. Die zuvor genannten Verbundfolien eignen sich allenfalls dazu, eine Folie herzustellen, welche aber nicht die notwendigen mechanischen Eigenschaften aufweist, dass darin direkt oder daran direkt elektronische Bauelemente transportfähig angeordnet werden können. Zur Bestückung von Automatisierungsgeräten im Pick-and-Place-Verfahren mit elektronischen Bauteilen oder Lötbauteilen zur Positionierung auf einer Leiterplatte, werden typischerweise auf Rollen aufgebrachte Bauteile verwendet.

Verpackungslösungen (Tape and Reel-Verpackungen) sind im Stand der Technik hinreichend bekannt zur Aufnahme von elektronischen Bauteilen. In der Regel besteht eine solche Verpackung aus einer ersten tiefgezogenen Trägerfolie beziehungsweise einem Tief-/Ziehband mit Aufnahmetaschen, in welche die elektronischen Bauelemente eingebracht werden und einer Abdeckfolie, die typischerweise als transparente Folie ausgebildet ist, zur Abdeckung der in dem Tief-/Ziehband befindlichen Taschen. Zwischen der Deckfolie und dem Trägerband befinden sich die zu positionierenden Bauteile beziehungsweise die elektronischen Kleinbauteile oder Lötelemente. Durch zunehmende Miniaturisierung besteht allerdings schon durch Fertigungstoleranzen die Problematik, die Bauteile exakt zu positionieren.

Ein weiterer Nachteil der herkömmlichen Transportbänder für elektronische Bauteile liegt in dem umfangreichen Logistikkreislauf und der aufwendigen Entsorgung derselben. Insbesondere werden bei sehr kleinen Bauteilen unverhältnismäßig große Verpackungsmengen benötigt, die dem Problem der Verwertung unterliegen und daher nicht als umweltfreundlich betrachtet werden können.

Ein weiterer Nachteil der im Stand der Technik bekannten Verpackungslösungen besteht darin, dass die Tief-/Ziehbänder mit Deckfolien verschweißt werden müssen und dieser zusätzliche Arbeitsschritt nicht nur kostenintensiv ist, sondern auch einer intensiven Prozessüberwachung bedarf.

### Aufgabenstellung

Aufgabe der vorliegenden Erfindung ist es somit, eine Verpackung bereit zu stellen, welche einerseits kompostierbar ist und andererseits die zuvor beschriebenen Nachteile der im Stand der Technik genannten Verpackungen für elektronische Bauelemente, vorzugsweise kleine elektronische Bauelemente löst, beziehungsweise diese Nachteile überwindet.

Weitere Aufgabe der vorliegenden Erfindung besteht darin, eine Verpackungslösung für solche elektronische Bauelemente bereit zu stellen, die ohne ein Tief-/Ziehprozess auskommt und welche so ausgebildet ist, dass elektronische Bauelemente an deren Oberfläche befestigt werden können, mittels Adhäsion, sprich durch Anhaften.

Weitere Aufgabe der vorliegenden Erfindung ist darin zu sehen, ein kompostierbares Material für solche Verpackungslösungen bereit zu stellen, was einerseits in typischen Spritz-/Gießmaschinen verarbeitet werden kann, wie klassische thermoplastische Materialien und gleichzeitig die Basis als Trägerschicht für eine Nano-Haftungsschicht bereitstellt; sprich eine Deckschicht auf welcher die zu platzierenden elektronischen Bauelemente angeordnet werden können.

Erfindungsgemäß wird die Aufgabe entsprechend der Merkmale des Anspruchs 1 gelöst.

Das erfindungsgemäße Verpackungsband wird als Verbundverpackung ausgestattet.

Im folgenden wird die Erfindung anhand einer kompostierbaren Verbundverpackungsrolle mit einem Pilotstreifen beschrieben.

Die Verpackung wird erfindungsgemäß durch einen mehrlagigen Verbundstoff, vorzugsweise aus Biokunststoff, insbesondere aus thermoplastischem Biokunststoff als mehriagiger Verbundstoff, hergestellt. Der mehrlagige Verbundstoff wird ausgebildet aus einem biologisch abbaubaren Biokunststoff als Trägerschicht, auf welchem mindestens eine Nano-Haftschicht angeordnet ist, die mit ihren Eigenschaften so ausgestattet ist, dass diese ebenfalls biologisch abbaubar und an deren Oberfläche eine hohe Adhäsionskraft aufweist, so dass darauf befestigte elektronische Bauelemente haften.

Erfindungsgemäß wird die Nano-Haftschicht so dünn ausgebildet, dass die Dicke der Nano-Haftschicht um ein vielfaches geringer ist als die Dicke der Trägerschicht aus Biokunststoff.

Die Trägerschicht kann beispielsweise auch aus Maismehl mit Bindemittel und anderen organischen Füllstoffen hergestellt werden, welche geeignet sind zum thermoplastischen Kunststoffspritzen.

Das Verfahren zum Spritzen solcher Verpackungseinheiten kann dann mittels einer herkömmlichen Kunststoffspritztechnik erzeugt werden, so dass ein weiterer Vorteil der hier vorliegenden Erfindung darin besteht, bestehende Herstellungsanlagen nicht modifizieren zu müssen, sondern allenfalls die Herstellungsparameter auf die Eigenschaften des zu verwendenden Biokunststoffs oder der zu verwendende Grundmateriallen anzupassen. Eine weitere Schicht an der Verbundverpackung kann beispielsweise auch als Papier/Karton oder gemahlener Cellulose unter Beigabe von biologisch abbaubaren und kompostierbaren Bindemitteln erreicht werden. Diese Schicht kann als einzelne Schicht beispielsweise in einem Superkalander ausgezeichnet werden und mittels Löchern versehen werden, so dass ein herkömmlicher Pilotstreifen gebildet wird. Das gesamte Verpackungsmaterial besteht insofern erfindungsgemäß, wahlweise aus Kombinationen eines ersten Pilotstreifens und/oder eines zweiten Pilotstreifens in Verbindung mit einer Trägerschicht, auf die eine Nano-Beschichtung aufgebracht ist, welche an ihrer aktiven Oberseite über eine solche Adhäsionskraft verfügt, dass die zu tragenden elektronischen Bauelemente von der Nano-Schicht gehalten werden.

Weitere Einzelheiten, Vorteile und erfindungswesentliche Merkmale ergeben sich aus der nachfolgenden Beschreibung des erfindungsgemäßen Verpackungsbandes beziehungsweise der Verpackung unter Bezugnahme auf die beigefügten Zeichnungen. Die Zeichnungen zeigen im einzelnen:
Fig. 1 eine Seitenansicht des erfindungsgemäßen kompostierbaren Verpackungsbandes;
Fig. 2 eine Draufsicht auf ein Verpackungsband, ausgebildet aus Verbundwerkstoff, gemäß Fig. 1 mit aufgebrachten Bauteilen.

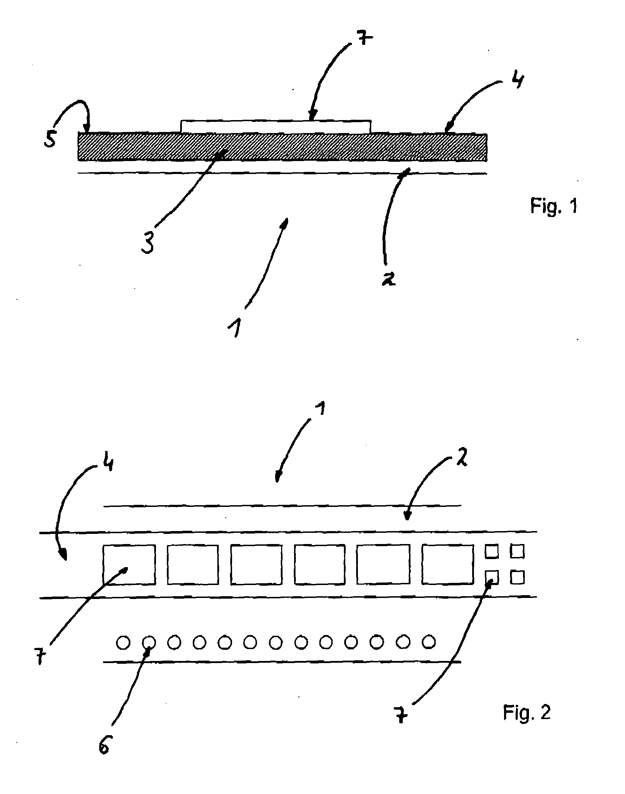

Das in Fig. 1 wiedergegebene Verbundverpackungsmaterial ist ein seiner Gesamtheit mit der Bezugsziffer 1 versehen. Es besteht aus einer Grundschicht 2, die vorzugsweise aus Papier oder Karton oder einem Cellulosegemisch mit hohem Recyclinganteil hergestellt ist. Dieses Material ist kostengünstig verfügbar und besitzt eine hinreichend hohe Festigkeit für die Herstellung des im folgenden beschriebenen Verbundwerkstoff, wie zum Beispiel eine Tape and Reel-Verpackung.

Diese Grundschicht 2 wird In Fig. 1 und Fig. 2 als Pilotstreifen mit einer Vielzahl von paarweise beabstandeten Löchern 6 zum Transport des Verpackungsbandes ausgestattet.

Die Transportlöcher 6 können einseitig, wie in Fig. 2 gezeigt, oder alternativ (wie nicht dargestellt) auch beidseitig angeordnet sein, sprich an beiden Längsseiten des hier vorgestellten Ausführungsbeispieles. Auf der Grundschicht 2 befindet sich die eigentliche Trägerschicht 3, welche aus thermoplastischem kompostierbaren Material. vorzugsweise aus Blokunststoff oder aus einer Verbindung mit einem hohen Anteil an Maismehl hergestellt wird. Die konkrete Auswahl von Bindemittel Füllstoffen und Maismehl beziehungsweise der Komposition des kompostierbaren Biokunststoffes, richtet sich nach den Bedürfnissen an das Verpackungsmaterial insgesamt. So kann durch geeignete Mischung die Flexibilität oder Festigkeit des Materials den gewünschten Anforderungen angepasst werden. Die Trägerschicht 3 wird beaufschlagt mit einer Nano-Haftungsschicht 4, welche dünn ausgebildet ist gegenüber der Dicke D1, also der Dicke der Trägerschicht 3 und der Dicke des Pilotstreifens 2. Diese Nano-Haftschicht 4 wird erzeugt durch ein flächenmäßig aufgebrachtes Nano-Klebematerial der Dicke D2, welches an seiner Oberfläche über eine Klebewirkung verfügt mit einem hinreichenden Hafteffekt, so dass das erfindungsgemäße Verbundmaterial an dieser Haftschicht elektronische Bauteile 7 an beliebigen Stellen und in beliebiger Orientierung aufnehmen kann.

Wie in Fig. 2 gezeigt, können Bauteile, insbesondere elektronische Bauelemente 7 preiswert und in jeder beliebigen Anordnung auf die Nano-Haftschicht aufgebracht werden. Die Bauteile oder elektronischen Bauelemente 7 können dann mittels Pick-and-Place-Verfahren von der Nano-Haftschicht 4 abgenommen werden. Durch diese Anordnung erhöht sich die Genauigkeit der Positionierung der Elemente, da diese nicht in Taschen oder in Ausnehmungen im Trägerband aufgenommen werden müssen. Gleichzeitig kann auch eine Deckfolie zum Halten der Elemente entfallen. Jedoch anders als im Stand der Technik bekannt, handelt es sich nicht um herkömmliche Kleber oder Klebefolien, die biologisch in der Regel nicht abbaubar sind, sondern um eine Nano-Beschichtung, die in ihrer Dicke D1 und D2 im Verhältnis zur Gesamtdicke des Verbundwerkstoffes nur minimal beiträgt. Hierdurch wird eine umweltfreundliche Verbundverpackung 1 erfindungsgemäß bereitgestellt.

Es soll an dieser Stelle noch einmal ausdrücklich angegeben werden, dass es sich bei der vorangegangenen Beschreibung lediglich um eine beispielhafte Ausführungsform handelt und das verschiedene Änderungen und Modifikationen möglich sind, ohne dabei den Rahmen der Erfindung zu verlassen. Dabei sind insbesondere weitere Einsatzmöglichkeiten für solche Verbundverpackungen vorgesehen, wie zum Beispiel die Aufnahme von Pflanzen- und Saatgut. Beispielsweise könnte anstelle von elektronischen Bauelementen auf der Nano-Beschichtung Saatgut in definiertem Abstand positioniert werden.

Alternativ könnte die längsgestreckte Verpackungsanordnung anstelle einer durchgehenden Verbundverpackung auch nur durch partiell auftretende Abschnitte dieser Verbundverpackung ausgebildet werden, die wiederum miteinander mittels einem dünnen Faden aus Biokunststoff verbunden sind, welcher ebenfalls vollständig verrotten und kompostierbar sind. Würde eine solche Anordnung beispielsweise in das Erdreich eingegraben werden, könnte ohne eine weitere Abstandsmessung oder ohne weitere Pflanzhilfe das Saatgut in vorbereitete Saatstreifen eingebracht werden. Weitere denkbare Einsatzmöglichkeiten sind für alle Bauteile oder Werkstoffe beziehungsweise auch Medikamente zu sehen, welche auf kostengünstige Art zu verpacken sind und welche über eine Fläche verfügen, die sich dazu eignet, an der Nano-Haftschicht angeordnet zu werden.

Eine weitere Ausführungsform der hier vorliegenden Erfindung wäre insbesondere darin zu sehen, dass die Nano-Haftschicht nur partiell auf dem Trägerstreifen beziehungsweise der Trägerschicht 3 angebracht sind.

### Bezugszeichenliste

### Kompostierbare Verpackung für elektronische Bauelemente

- 1: Verbundverpackung
- 2: Pilotstreifen/Grundschicht
- 3: Trägerschicht
- 4: Nano-Haftschicht
- 5: Haftoberfläche
- 6: Transportlöcher
- 7: Bauelemente

- D1: Dicke
- D2: Dicke

- F: Haftkraft

## Patentansprüche

1. Verbundverpackung (1) für elektrische Bauelemente aus mindestens zwei Schichten (2, 3, 4) **dadurch gekennzeichnet, dass** die Schichtmaterialien der Schichten (2, 3, 4) sowohl einzeln als auch in Kombination miteinander vollständig bioabbaubar oder kompostierbar sind.

2. Verbundverpackung (1) gemäß Anspruch 1, **dadurch gekennzeichnet, dass** die Schicht (3) als Trägerschicht ausgebildet ist zur Aufnahme mindestens einer weiteren Schicht (2, 4).

3. Verbundverpackung (1) gemäß Anspruch 2, **dadurch gekennzeichnet, dass** die Schicht (4) als Nano-Haftschicht (4) auf der Trägerschicht (3) ausgebildet ist.

4. Verbundverpackung (1) gemäß einem der vorhergehenden Ansprüche, **dadurch gekennzeichnet, dass** die Nano-Haftschicht (4) mit einer adhäsiven Haftoberfläche (5) ausgestattet ist, deren Haftkraft (F) auf die aufzunehmenden Bauelemente abgestimmt ist.

5. Verbundverpackung (1) gemäß einem der vorhergehenden Ansprüche, **dadurch gekennzeichnet, dass** die Nano-Haftschicht (4) eine Dicke (D2) aufweist, die deutlich geringer ausgebildet ist als die Dicke (D1) der Trägerschicht (3), vorzugsweise weniger als 10 % der Dicke (D1).

6. Verbundverpackung (1) gemäß einem der vorhergehenden Ansprüche, **dadurch gekennzeichnet, dass** die Nano-Haftschicht (4) im wesentlichen auf der gesamten Oberfläche der Trägerschicht (3) aufgebracht ist.

7. Verbundverpackung (1) gemäß Anspruch 1 bis 5, **dadurch gekennzeichnet, dass** die Nano-Haftschicht (4) partiell an der Oberfläche der Trägerschicht (3) aufgebracht ist.

8. Verbundverpackung (1) gemäß einem der vorhergehenden Ansprüche, **dadurch gekennzeichnet, dass** eine dritte Schicht (2) ausgebildet als Grundschicht (2) an der Unterseite der Trägerschicht (3) gegenüber der Nano-Haftschicht (4) ausgebildet angeordnet ist.

9. Verbundverpackung (1) gemäß Anspruch 8, **dadurch gekennzeichnet, dass** die Grundschicht (2) als Pilotstreifen (2) aus Papier oder papierähnlichem Material mit einem hohen Celluloseanteil ausgebildet ist.

10. Verbundverpackung (1) gemäß Anspruch 8 oder 9, **dadurch gekennzeichnet, dass** die Verbundverpackung (1) rollbar ausgebildet ist und zu einer Verpackungsspule aufgerollt werden kann.

11. Verbundverpackung (1) gemäß einem der vorhergehenden Ansprüche, **dadurch gekennzeichnet, dass** eine Vielzahl von im wesentlichen rechteckigen flachen Bauelementen auf der Oberseite der Nano-Haftschicht (4) derart angeordnet sind, dass diese lösbar in folge von einer Haftkraft mit dieser in Wirkverbindung stehen.

12. Verfahren zum Herstellen einer Verbundverpackung gemäß einem der vorhergehenden Ansprüche 1 bis 11, mit den folgenden Schritten:
a) Bereitstellen einer Trägerschicht (3) aus Biokunststoff, welche vollständig kompostierbar ist,
b) Aufbringen einer dünnen kompostierbaren Nano-Schicht (4) auf die Trägerschicht (3) mit einer Klebeoberfläche mit einer Haftkraft F, ausgebildet zur Aufnahme von elektronischen Bauelementen 7,
c) Anordnen eines Pilotstreifens (2) an der Unterseite der Trägerschicht (3).
